## Europäisches Patentamt
## European Patent Office
## Office européen des brevets

(19)

(11) Veröffentlichungsnummer: **0 214 464**
**A1**

(12) # EUROPÄISCHE PATENTANMELDUNG

(21) Anmeldenummer: **86110752.2**

(22) Anmeldetag: **04.08.86**

(51) Int. Cl.⁴: **H 01 L 31/02**
**G 02 B 6/42, H 01 L 33/00**

(30) Priorität: **05.09.85 DE 3531746**

(43) Veröffentlichungstag der Anmeldung:
**18.03.87 Patentblatt 87/12**

(84) Benannte Vertragsstaaten:
**AT BE CH DE FR GB IT LI NL SE**

(71) Anmelder: **Siemens Aktiengesellschaft Berlin und München**
**Wittelsbacherplatz 2**
**D-8000 München 2(DE)**

(72) Erfinder: **Frenkel, Ferdinand, Dr.-Phys.**
**Elisenstrasse 10**
**D-8900 Augsburg 1(DE)**

(72) Erfinder: **Prussas, Herbert, Dipl.-Ing.**
**Mozartring 11**
**D-8069 Reichertshausen(DE)**

(72) Erfinder: **Rapp, Lothar**
**Gabriele-Münter-Strasse 7**
**D-8000 München 71(DE)**

(54) Gehäuse für ein optoelektronisches Schaltungsmodul.

(57) Gehäuse (1, 2, 3) für ein optoelektronisches – z.B. in einem Glasfaser-Kommunikationssystem angewendetes – Schaltungsmodul (6, 13, 10) –, wobei im Gehäuse-Inneren eine freie, also in einem Vakuum oder Gas verlaufende Lichtstrecke (12) zwischen zwei hinsichtlich ihrer gegenseitigen Lage justierten optischen Bauelementen (4, 6) angebracht sind. Das erste optische Bauelemente (4) ist über eine erste Halterung (5) sowie das zweite optische Bauelement (6) über eine zweite Halterung (7) am Gehäuse (1, 2, 3) befestigt. Die erste Halterung (5) ist, wenn nicht im Gehäuse-Inneren dann in einer der Gehäusewände (3) angebracht. Die zweite Halterung (7), welche an einem Abschnitt (innerhalb 1) des Gehäuses (1, 2, 3) starr befestigt ist, ist im Gehäuse-Inneren angebracht. Bei der Anwendung des Schaltungsmoduls ist zumindest die zweite Halterung (7) hohen Temperaturschwankungen – z.B. zwischen – 40°C bis zu + 130°C – ausgesetzt. Zumindest der an die zweite Halterung (7) angrenzende Abschnitt (innerhalb 1) des Gehäuses (1, 2, 3) besteht aus einem schweißbaren ersten Material, welches einen ersten linearen Wärmeausdehnungs-Koeffizienten aufweist. Zumindest der an den Abschnitt (innerhalb 1) angrenzende Teil der zweiten Halterung (7) besteht aus einem schweißbaren zweiten Material, welches einen zweiten, vom ersten linearen Wärmeausdehnungs-Koeffizienten stark abweichenden linearen Wärmeausdehnungs-Koeffizienten aufweist. Mindestens ein, im Betrieb eine Aufheizung durch Verlustwärme bewirkendes, elektronisches Bauelement (13, 10), z.B. ein durch eine Infrarot-Lichtsendediode (13) gebildetes optoelektronisches Bauelement, ist im Gehäuse (1, 2, 3)-Inneren angebracht. Die zweite Halterung (7) grenzt zwar an den relativ großen Abschnitt (innerhalb 1) an, ist aber nur über eine demgegenüber kleine, weitgehend punktförmige Stelle (8) dieses Abschnittes (innerhalb 1) verschweißt.

Siemens Aktiengesellschaft
Berlin und München

Unser Zeichen:
VPA 85 P 1 6 0 5 E

0214464

Gehäuse für ein optoelektronisches Schaltungsmodul.

Die Erfindung geht von einem speziellen, im Oberbegriff des Patentanspruches 1 definierten Gehäuse aus, welches für sich z.B. aus der DE-OS 33 37 131 vorbekannt ist. Dort wird das erste optische Bauelement durch das Ende einer Glasfaser gebildet, und das zweite optische Bauelement durch eine optoelektronische Halbleiterdiode, wobei dort die Lichtstrecke extrem kurz ist und deren Justierung sogar Toleranzen von 1μ und teilweise noch weit darunter einhalten muß.

Die Justierung der Lichtstrecke, also die Justierung der beiden optischen Bauelemente, muß auch bei Betriebstemperaturschwankungen möglichst unverändert bleiben. Die Erfindung hat die Aufgabe, mit möglichst einfachen Mitteln die Toleranz für die zulässigen Betriebstemperaturen und damit für zulässige Betriebstemperaturschwankungen des fertig montierten Gehäuses sehr groß machen zu können, z.B. Schwankungen von -40° C bis zu +80° C oder gar bis +130° C und bei Bedarf noch darüber hinaus, zulassen zu können, ohne für den Betrieb des Gehäuses schädliche mechanische innere Spannungen im Gehäuse riskieren zu müssen. Solche innere Spannungen im Gehäuse können nicht nur Abplatzungen der Befestigung zwischen dem Gehäuseabschnitt und der zweiten Halterung auslösen, sondern in vielen Fällen auch durch mehr oder weniger starke Verbiegungen mehr oder weniger starke optische Dejustierungen der Lichtstrecke auslösen.

Diese Aufgabe wird erfindungsgemäß durch die im Patentanspruch 1 angegebenen Maßnahmen gelöst.

Be 1 Ky/30.08.85

0214464

Die in den Unteransprüchen angegebenen Maßnahmen gestatten, zusätzliche Vorteile zu erreichen. Es gestatten nämlich die Maßnahmen gem. Patentanspruch

2, den Abstand zwischen den Befestigungen der Halterungen am Gehäuse ganz besonders groß zu wählen, statt ihn zur Vermeidung von inneren Spannungen und daraus sich ergebenden optischen Dejustierungen in jedem Fall möglichst klein machen zu müssen;

3, mit besonders hoher Präzision optische Dejustierungen in einem ganz besonders großen Temperaturbereich vermeiden zu können, und zwar selbst dann, wenn der Abstand der Befestigung der Halterungen am Gehäuse extrem viel größer ist, z.B. 10 000fach größer ist, als die Länge der Lichtstrecke;

4, eine großflächige starre Befestigung des zweiten Bauelementes - also z.B. eines Prismas, einer Linse oder eines sonstigen großen massiven optischen zweiten Bauelementes - an der ganz oder im wesentlichen aus dem zweiten Material bestehenden zweiten Halterung zulassen zu können;

5, die Wärmebelastung insbesondere des zweiten optischen Bauelements und/oder der zweiten Halterung möglichst klein machen zu können, indem die Verlustwärme des elektrischen Bauteils bzw. der elektrischen Bauteile jeweils über einen Wärmeableitkörper, z.B. über eine wärmeleitende Feder aus CuNiBe-Legierung, mit möglichst kleinem Wärmewiderstand unmittelbar an das Gehäuse und über die Gehäuseaußenoberfläche an äußere Wärmesenken, z.B. an vorbeiströmende Kühlluft, abgegeben wird;

6, das Gehäuse für ein Modul eines Glasfaser-Kommunikationssystems mit einem elektrisch-optischen Wandler verwenden zu können;

7, als Wandler einen inneren Aufbau im Gehäuse ähnlich wie in der genannten DE-OS 33 37 131 verwenden zu können;

8, den Wandler als Richtungskoppler verwenden zu können,
welcher mindestens zwei optoelektronische Bauelemente
optisch mit der Glasfaser verbindet;

9, die Lage der zu verschweißenden Stelle zuverlässig
festlegen zu können; sowie

10,unerwünschte Verschweißungen abseits der zu verschweißenden Stelle zwischen der zweiten Halterung
und dem Abschnitt des Gehäuses vermeiden zu können.

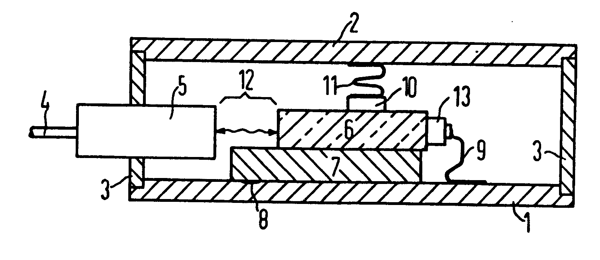

Die Erfindung und ihre Weiterbildungen werden anhand
des in der Figur gezeigten Beispiels der Erfindung
weiter erläutert. Diese Figur zeigt ein aus dem Boden 1,
den Seitenwänden 3 und dem Deckel 2 bestehendes Gehäuse
für ein optoelektronisches Schaltungsmodul eines Glasfaser-Kommunikationssystems. Dieses Gehäuse hat z.B.
außen die Maße 25mm x 15mm x 8,5mm.

Im Inneren des Gehäuses befindet sich eine freie Lichtstrecke 12, welche also in einem Vakuum oder in einem
Gas verläuft. Zur besseren Veranschaulichung ist die
Länge der Lichtstrecke 12 in der Figur sehr groß gezeigt, sie kann jedoch auch extrem klein sein, z.B. nur
wenige μm oder sogar noch viel weniger betragen, vgl. z.B.
die Lichtstrecke in DE-OS 33 37 131. Die Länge der Lichtstrecke wird durch die gegenseitige Lage der sie begrenzenden optischen Bauelemente 4,6 definiert, wobei im
gezeigten Beispiel das erste optische Bauelement 4 das
Ende der Glasfaser 4 in deren Anschluß 5 ist und wobei
das zweite optische Bauelement 6 z.B. durch eine optoelektronische Halbleiterdiode 6, also z.B. durch eine
Infrarot-Lichtsendediode 6 gebildet wird, vgl. wieder
die DE-OS 33 37 131. Die gegenseitige Lage der beiden
optischen Bauelemente 4,6 bestimmt durch ihre gegenseitige . Justierung die Länge und die Richtung der Lichtstrecke 12 im Gehäuse 1,2,3.

Diese  Justierung der Lichtstrecke muß mitunter sehr enge Toleranzen einhalten, vgl. z.B. wieder die DE-OS 33 37 131. Diese  Justierung hat nicht nur die oft sehr kleine Toleranz in axialer Richtung bez. Glasfaser 4, sondern oft auch eine sogar besonders geringe Toleranz in radialer Richtung bez. Glasfaser 4.

Es zeigt sich, daß besonders die inneren mechanischen Spannungen im Gehäuse zu solchen Verbiegungen der mechanischen Bestandteile des Gehäuses führen, daß die Justierung der Lichtstrecke 12 bei starken Temperaturschwankungen nicht mehr die geforderten Toleranzen einhielt. Insbesondere zeigte sich, daß bei dem in der Figur gezeigten Beispiel sich der Boden 1 des Gehäuses bei Temperaturschwankungen .  so stark konvex oder konkav verformte, daß die radiale Justierung der Lichtstrecke 12 nicht die gewünschte Toleranz von z.B. $\pm$ 0,2/um einhielt. Auch in axialer Richtung, bezogen auf die Glasfaser 4, waren erhebliche Änderungen  der Länge der Lichtstrecke 12 hierbei mitunter zu beobachten.

Eine genaue Untersuchung ergab, daß die starken Verformungen vor allem des Gehäusebodens 1 dadurch vermieden werden konnten, daß der in der Figur schematisch gezeigte Sockel 7 des zweiten optischen Bauelements 6 - der Sockel 7 stellt eine Halterung des zweiten optischen Bauelementes 7 dar und grenzt großflächig an den Boden 1 an und war ursprünglich ebenfalls großflächig starr mit dem Boden 1 verbunden - nur noch über eine kleine, weitgehend punktförmige Stelle 8 mit dem Boden 1 verschweißt wurde. Die Fläche der Stelle 8 hatte nach dem Verschweißen z.B. nur wenige % der Größe, welche die dem Boden 1 zugewandte, an den Boden 1 angrenzende Grundfläche des Sockels 7 aufwies. Damit waren jene inneren mechanischen Spannungen am Boden 1 weitgehend vermieden, welche bei starken Temperaturschwankungen aufgrund der sehr unterschiedlichen linearen Wärmeausdehnung-Koeffizienten der Materialien des Bodens 1 und des Sockels 7 auftreten.

Daraus wird erfindungsgemäß folgende allgemeine Regel abgeleitet:

Voraussetzung ist, daß bei dem Gehäuse 1,2,3 mit freier Lichtstrecke 12 zwischen den beiden optischen Bauelementen 4,6 - also z.B. zwischen Prismen, Linsen, Glasfasertapern oder dgl. - das erste optische Bauelement irgendwie am Gehäuse befestigt ist, also seine erste Halterung 5, wenn nicht innerhalb des Gehäuses 1,2,3, dann zumindest an einer der Gehäusewände 3 angebracht ist. Voraussetzung ist außerdem, daß die zweite Halterung 7, welche das zweite optische Bauelement 6 hält, an einem Abschnitt des Gehäuses im Gehäuseinneren befestigt ist, vgl. in der Figur den betreffenden Abschnitt auf der Innenoberfläche des Bodens 1. Sowohl das Material am betreffenden Abschnitt, vgl. den Boden 1, als auch zumindest der an diesen Abschnitt angrenzende Teil der zweiten Halterung 7 ist jeweils aus miteinander verschweißbaren Materialien hergestellt, wobei das Material des Abschnittes, vgl. 1, einen stark abweichenden linearen Wärmeausdehnungs-Koeffizienten, bezogen auf das andere Material der zweiten Halterung 7, aufweist . Außerdem ist eine starke Temperaturschwankung vorausgesetzt,z.B. beim Einsatz in einem Gasfaser-Kommunikationssystem, welches auch unter extremen Temperaturbedingungen absolut betriebssicher sein muß: von extremer Kälte, also z.B. -60°C oder -40°C bis zu sehr hohen Betriebstemperaturen im Inneren des Gehäuses von z.B. 80°C oder sogar weit darüber, z.B. 130°C. Solche starken Aufheizungen treten z.B. im Betrieb eines solchen Schaltungsmoduls eines Glasfaser-Kommunikationssystems auf, weil im Inneren des Gehäuses 1,2,3 ein elektronisches Bauelement, z.B. ein optoelektronisches Bauelement - also z.B. eine Infrarot-Lichtsendediode und/oder ein Vorverstärker (also z.B. ein Halbleiter-Treiber-Chip) angebracht ist. Solche elektro-

0214464

nischen Bauelemente geben im Betrieb oft sehr hohe, mitunter stark wechselnde Verlustwärmen ab, welche eine oft relativ sehr starke Aufheizung des oft besonders kleinen Gehäuses darstellt. Darüber hinaus sind solche Gehäuse 1,2,3 von optoelektronischen Schaltungsmodulen eines Glasfaser-Kommunikationssystems außen sehr schwer ausreichend kühlbar, weil extrem viele solcher Gehäuse 1,2,3 auf allerengsten Raume in großen Schränken unterzubringen sind, so daß die Zuführung von Kühlluft erschwert ist und überdies die gesamte, von allen Gehäusen 1,2,3 über die Kühlluft abzuführende Verlustwärme außerordentlich groß ist. Die Gehäuse sollen also im Betrieb möglichst auch extrem große Temperaturschwankungen ohne jegliche Störungen der Kommunikationen mit extremer Zuverlässigkeit langzeitstabil gewährleisten. Die Erfindung gestattet also auch unter solchen sehr erschwerten Betriebsbedingungen äußerst enge Toleranzen der Justierung der Lichtstrecke 12 einzuhalten, indem unter den genannten Voraussetzungen die zweite Halterung 7 zwar an den relativ großen Abschnitt des Gehäuses, hier des Bodens 1, angrenzt, aber trotzdem nur über eine, gegenüber diesem großen Abschnitt relativ kleine, weitgehend punktförmige Stelle 8 dieses Abschnittes verschweißt ist.

Eine solche punktförmige Verschweißung an einem nur sehr kleinen Teil der Fläche der insgesamt relativ großen Fläche des Abschnittes kann man auf verschiedene Weise herstellen. Man kann z.B., vgl. die Figur, im Boden 1 an der betreffenden Stelle 8 vor dem Verschweißen einen Noppen einprägen, welcher eine leichte Erhebung im Gehäuseinneren darstellt,            wonach man die flache betreffende Grundfläche der Halterung 7 auf den Gehäuseboden 1 aufdrückt und bei 8 verschweißt. Außer einer solchen Erhebung - welche auch an der Grundfläche der Halterung 7 statt am Boden 1 angebracht werden kann - kann man auch zusätzlich jene Teile des Abschnittes zwi-

schen der Halterung 7 und dem Boden 1 mit einem elektrisch isolierenden (ausgehärteten) Lack bedecken, welche nicht zu verschweißen sind. Dieser Lack bewirkt, daß mit hoher Zuverlässigkeit nur an der kleinen Stelle 8 die Verschweißung mit sehr geringer Ausschußquote herstellbar ist. Darüber hinaus kann man, statt einer an der zu verschweißenden Stelle 8 angebrachten Erhebung, vor dem Verschweißen an dieser Stelle 8 zwischen dem Boden 1 und der Halterung 7 ein kleines Metallstück, z.B. einen Blechstreifen anbringen, oder z.B. ein kleines Stück Draht anbonden, wobei solche zusätzlichen Metallteile zwischen dem Abschnitt des Gehäuses und der Halterung 7 ähnlich wie die vorher genannten Erhebungen beim Verschweißen bewirken, daß gerade an dieser Stelle 8 die punktförmige Verschweißung beim Punktschweißen eintritt.

Aus der bisherigen Beschreibung geht bereits hervor, daß der an die zweite Halterung 7 angrenzende Abschnitt des Gehäuses nicht unbedingt ein Abschnitt des Bodens 1 des Gehäuses sein muß. Statt dessen kann es auch ein andere Bestandteil des Gehäuses, z.B. der Deckel 2 oder eine Seitenwand 3 des Gehäuses sein. Ebenso kann es z.B. ein zusätzlicher Podest im Inneren des Gehäuses sein, welcher seinerseits irgendwo an einen äußeren Bestandteil 1,2,3 des Gehäuses mittelbar oder unmittelbar befestigt ist. Daraus geht auch hervor, daß also beide Halterungen 5,7 der beiden optischen Bauelemente 4,6 jeweils über weitere mechanische Bauteile miteinander starr verbunden sein können, ohne den erfindungsgemäßen Vorteil der Vermeidung der inneren mechanischen Spannungen bei Temperaturschwankungen zu verlieren. Die Erfindung ist also vorteilhafterweise nicht an einen ganz speziellen Aufbau im Inneren des Gehäuses 1,2,3 gebunden. Insbesondere sind also die betreffenden inneren Spannungen bei starken Temperaturschwankungen auch dann vermeidbar,

wenn die Halterungen 5,7, für sich betrachtet, praktisch eine beliebige Form bzw. Konstruktion haben. Die Erfindung hat also einen entsprechend großen Anwendungsbereich.

Besonders exakt wird die Toleranz für die Lichtstrecke selbst bei extrem großen Temperaturschwankungen dann eingehalten, wenn die Stelle 8, an welcher der Abschnitt des Gehäuses mit der zweiten Halterung verschweißt wird, mit ganz besonderem Bedacht gewählt wird. Jedes der verschiedenen Teile, vgl. 4,5,3,1,7,6 in der Figur, können für sich aus völlig verschiedenen Materialien bestehen, welche jeweils voneinander völlig abweichende lineare Wärmeausdehnungs-Koeffizienten aufweisen. Bei jeder Temperatur wirkt also jedes dieser verschiedenen Teile 4,5,3,1,7,6 jeweils für sich dejustierend auf die Lichtstrecke 12, und zwar nicht nur in Längsrichtung, d.h. beim gezeigten Beispiel in Richtung der Achse der Glasfaser 4, sondern auch senkrecht dazu, also radial zur Glasfaser 4. Die verschiedenen Ausdehnungen der verschiedenen Teile 4,5,3,1,7,6 werden sich im allgemeinen teils addieren teils subtrahieren , je nach der Form und dem Material und dem Ort der Anbringung des betreffenden Teiles. Man kann nun den Abschnitt, an welchem die zweite Halterung an das Gehäuse angrenzt, im Prinzip innerhalb des Gehäuses nahezu beliebig ändern, und erst recht kann man innerhalb dieses Abschnittes die Lage der Stelle 8 im Prinzip beliebig ändern, unabhängig davon, aus welchen Materialien die einzelnen Teile 4,5,3,1,7,6 jeweils bestehen und welche Form sie haben. Es ist also besonders günstig, die Stelle 8 innerhalb des Abschnittes, vgl. 1, so zu wählen, daß sich alle durch Temperaturänderungen bewirkten Wärmeausdehnungen sämtlicher Bauteile 4,5,3,1,7,6 zwischen den Enden der Lichtstrecke zumindest weitgehend gegenseitig kompensieren. Bei dem in der Figur gezeigten Beispiel ist die Achse der Glasfaser 4 parallel zur Fläche des Abschnittes auf dem Bo-

0214464

den 1, in welchem die Stelle 8 liegt: Bez. Temperaturschwankungen wird dann wegen der verschiedenen Wärmeausdehnungskoeffizienten durch geschickte Wahl der Stelle 8 die Dejustierung der Lichtstrecke 12 minimierbar.

Die Dejustierung der Lichtstrecke 12 wird noch besser
dadurch eliminierbar, wenn die Richtung der Lichtstrecke
12, also im gezeigten Beispiel die Richtung der Achse
der Glasfaser 4, nicht mehr parallel zur Fläche des Abschnittes gewählt wird, sondern in optimaler Weise
schräg dazu, und zwar mit solcher Schräge, daß bei entsprechender Wahl der Lage der Stelle 8 sowohl die axialen als auch die radialen Dejustierungen der Lichtstrecke 12 minimiert werden.

Die Erfindung ist also nicht auf die Wahl ganz spezieller linearer Wärmeausdehnungskoeffizienten für die
verschiedenen Bauteile 4,5,3,1,7,6 beschränkt, also
auf die Anwendung einer einzigen ganz speziellen Materialkombination und Formkombination beschränkt. Daher
gestattet die Erfindung auch, daß das zweite optische
Bauelement 6 aus einem Material besteht, welches seinerseits einen dritten linearen Wärmeausdehnungs-Koeffizienten aufweist, welcher, verglichen mit den übrigen linearen Wärmeausdehnungs-Koeffizienten im wesentlichen dem zweiten linearen Wärmeausdehnungs-Koeffizienten der eigenen zweiten Halterung 7 zumindest recht
ähnlich ist. Dann kann man nämlich das zweite optische
Bauelement 6 großflächig starr mit seiner zweiten Halterung 7 verbinden, ohne erhebliche mechanische innere
Spannungen an dieser Verbindung zwischen dem optischen
Bauelement 6 und seiner zweiten Halterung 7 allzusehr
befürchten zu müssen.

Die Erfindung ist auch nicht auf ganz spezielle elektronische Bauelemente beschränkt, welche die Verlustwärme im Betrieb abgeben. Wenn jedoch diese elektroni-

0214464

schen Bauelemente stark und relativ schnell schwankend
Verlustwärme abgeben, wird die gut wärmeleitend mit
diesem elektronischem Bauelement verbundene Umgebung
des Gehäuses entsprechend der Wärmeausbreitungsgeschwindigkeit starken Temperaturschwankungen ausgesetzt, jedoch die entfernteren Teile dieses Gehäuses nur sehr
geringen Temperaturschwankungen und überdies nur zeitlich verzögert. Die rhythmische Dejustierung der Lichtstrecke 12 ist dann mitunter viel größer, als zugelassen
werden kann. Besonders in diesem Fall ist es günstig,
wenn die Verlustwärme abgebenden elektronischen Bauelemente, zumindest ein Teil derselben, jeweils über Wärmeableitkörper, vgl. 9 und 11, mit solchen Gehäuse-Innenoberflächen gut wärmeleitend verbunden sind, über welche
die Verlustwärme sehr rasch über die Gehäuse-Außenoberfläche an die äußere Umgebung abgegeben werden kann.
Als solche Wärmeableitkörper 9,11 eignen sich z.B. Federn
aus gut wärmeleitendem Material, also z.B. aus einer
CuNiBe-Legierung, weil Federn gestatten, große Toleranzen zwischen den beiden Enden der Federn zuzulassen.

Für Module in einem Glasfaser-Kommunikationssystem
werden besonders solche erfindungsgemäß aufgebaute Gehäuse benötigt, deren erstes optisches Bauelement 4
das Ende einer Glasfaser ist, welches im allgemeinen von
einem steckbaren Glasfaseranschluß 5 als erste Halterung
gehalten wird. Sie weisen evtl. sogar zwei Lichtstrecken im
Gehäuse auf, von denen jede für sich erfindungsgemäß
angebracht sein kann: nämlich eine erste Lichtstrecke
zwischen dem Ende der Glasfaser 4 und einer Sammellinse, z.B. Kugellinse, zur schärferen Bündelung des Lichtes,
sowie eine zweite Lichtstrecke zwischen dieser Sammellinse und einem optoelektronischen Bauelement. Außerdem
können zwischen der Lichtstrecke und dem optoelektronischen
Bauelement noch weitere optische Bauelemente starr angeordnet und dabei optisch dem optoelektronischen Bauelement
vorgeschaltet sein: z.B. ein Quarzkörper oder ein Glaskörper, welcher z.B. in sich eingebettet Glasfasern in solcher Weise enthält, daß er als Richtungskoppler dient, welcher in sich den über die Glasfaser führenden Lichtweg in mehrere Lichtwegzweige aufzweigt, z.B. zu zwei gleichzeitig im Gehäuseinneren angebrachten optoelektronischen Bauelementen, vgl. 13 und 10 in der Figur.

Bei einem solchen Richtungskoppler kann also z.B. das eine elektronische Bauelement13 eine Lichtsendediode sein, welche eine andere Lichtwellenlänge liefert, als die andere Lichtsendediode 10. Falls Lichtsendedioden im Gehäuseinneren angebracht sind, wird deren Licht im allgemeinen jeweils über die Glasfaser 4 aus dem Gehäuse 1, 2, 3 hinaus geleitet. Falls Lichtempfangsdioden im Inneren des Gehäuses vorgesehen sind, wird ihnen Licht im allgemeinen über die Glasfaser 4 von außen her zugeleitet. Statt zweier Lichtsendedioden 13 10 können also dort auch jeweils andere Bauelemente, z.B. zwei Lichtempfangsdioden13, 10 angebracht sein.

10 Patentansprüche
 1 Figur

VPA 85 P 1605                                        **0214464**

<u>B e z u g s z e i c h e n l i s t e</u>

| | |
|---|---|
| 1 | Boden |
| 2 | Deckel |
| 3 | Gehäusewand |
| 4 | Bauelement |
| 5 | Halterung (Glasfaseranschluß) |
| 6 | Bauelement |
| 7 | Halterung (Sockel) |
| 8 | Stelle |
| 9 | Wärmeableitkörper (Feder) |
| 10 | Bauelement |
| 11 | Wärmeableitkörper (Feder) |
| 12 | Lichtstrecke |
| 13 | Bauelement |

0214464

VPA 85 P 1 6 0 5 E

Patentansprüche

1. Gehäuse(1, 2, 3) für ein optoelektronisches - z.B. in einem Glasfaser-Kommunikationssystem angewendetes - Schaltungsmodul(6,13, 10) - , wobei

- im Gehäuse(1, 2, 3)-Inneren eine freie, also in einem Vakuum oder in einem Gas verlaufende, Lichtstrecke(12) zwischen zwei hinsichtlich ihrer gegenseitigen Lage justierten optischen Bauelementen(4, 6) - also z.B. Prismen, Linsen, Glasfasertapern o.dgl. - angebracht sind,

- das erste optische Bauelemente(4) über eine erste Halterung(5) sowie das zweite optische Bauelement(6) über eine zweite Halterung(7) am Gehäuse(1, 2, 3) befestigt sind,

- die erste Halterung(5), wenn nicht im Gehäuse (1, 2, 3)-Inneren dann in einer der Gehäusewände(3) angebracht ist,

- die zweite Halterung(7), welche an einem Abschnitt(innerhalb 1) des Gehäuses(1, 2, 3) starr befestigt ist, im Gehäuse(1, 2, 3)-Inneren angebracht ist,

- bei der Anwendung des Schaltungsmoduls zumindest die zweite Halterung(7) hohen Temperaturschwankungen - z.B. zwischen -40° C bis zu +130° C - ausgesetzt ist,

- zumindest der an die zweite Halterung(7) angrenzende Abschnitt(innerhalb 1) des Gehäuses(1, 2, 3) aus einem schweißbaren ersten Material besteht, welches einen ersten linearen Wärmeausdehnungs-Koeffizienten aufweist,

- zumindest der an den Abschnitt(innerhalb 1) angrenzende Teil der zweiten Halterung(7) aus einem schweißbaren zweiten Material besteht, welches einen zweiten, vom ersten linearen Wärmeausdehnungs-Koeffizienten stark abweichenden linearen Wärmeausdehnungs-Koeffizienten aufweist, und

- mindestens ein, im Betrieb eine Aufheizung durch Verlustwärme bewirkendes, elektronisches Bauelement(13, 10), z.B. ein durch eine Infrarot-Lichtsendediode(13) gebildetes optoelektronisches Bauelement, im Gehäuse(1, 2, 3)-Inneren angebracht ist,

d a d u r c h   g e k e n n z e i c h n e t , daß

- die zweite Halterung(7) zwar an den relativ großen Abschnitt(innerhalb 1) angrenzt, aber nur über eine
demgegenüber kleine, weitgehend punktförmige Stelle(8)
dieses Abschnittes(innerhalb 1) verschweißt ist.


2. Gehäuse nach Patentanspruch 1,
d a d u r c h   g e k e n n z e i c h n e t , daß

- beide Halterungen(5, 7) über weitere mechanische Bauteile (3, 1) miteinander starr verbunden sind.


3. Gehäuse nach Patentanspruch 1 oder 2,
d a d u r c h   g e k e n n z e i c h n e t , daß

- die Stelle(8) so innerhalb des Abschnittes(1) gewählt
ist, daß sich alle durch Temperaturänderungen bewirkten
Wärmeausdehnungen aller Bauteile(5, 3, 1, 7) zwischen
den beiden optischen Bauelementen(4, 6) zumindest weitgehend gegenseitig kompensieren.


4. Gehäuse nach Patentanspruch 1, 2 oder 3,
d a d u r c h   g e k e n n z e i c h n e t , daß

- das zweite optische Bauelement(6) aus einem Material besteht, welches einen dritten linearen Wärmeausdehnungs-
Koeffizienten, welcher, verglichen mit dem ersten und
zweiten linearen Wärmeausdehnungs-Koeffizienten, dem
zweiten linearen Wärmeausdehnungs-Koeffizienten sehr
ähnlich ist.


5. Gehäuse nach einem der vorhergehenden Patentansprüche,
d a d u r c h   g e k e n n z e i c h n e t , daß

- zumindest ein Teil seiner im Betrieb Verlustwärme abgebenden elektronischen Bauelemente(13,10) über eigene
Wärmeableitkörper(9, 11) mit einer Gehäuse(1, 2, 3)-
Innenoberfläche wärmeleitend verbunden ist.

0214464

6. Anwendung des Gehäuses nach einem der vorhergehenden Patentansprüche in einem Glasfaser-Kommunikationssystem, d a d u r c h   g e k e n n z e i c h n e t , daß

- das erste optische Bauelement(4) das Ende einer Glasfaser(4), welches von einem Glasfaseranschluß(5) als erste Halterung(5) gehalten wird, ist,
- mindestens eines der elektronischen Bauelemente(6 oder 13, 10) eine Lichtsendediode (6 oder 13, 10) ist, deren Licht gebündelt über die Lichtstrecke(12) und weiter über die Glasfaser(4) aus dem Gehäuse(1, 2, 3) hinaus geleitet wird.


7. Anwendung nach Patentanspruch 6, d a d u r c h   g e k e n n z e i c h n e t , daß
- das zweite optische Bauelement(6) ein optoelektronisches Bauelement(6), nämlich eine Lichtsendediode(6) ist, welche von einem metallischen Sockel(7) als zweite Halterung(7) gehalten wird.


8. Anwendung nach Patentanspruch 6, d a d u r c h   g e k e n n z e i c h n e t , daß
- das zweite optische Bauelement(6) einen, einen Quarzkörper oder Glaskörper enthaltender, Richtungskoppler(6) ist, welcher optisch mit zwei im Gehäuse(1, 2, 3)-Inneren angebrachten optoelektronischen Bauelementen(13, 10) verbunden ist, und
- das zweite optische Bauelement(6) von einem metallischen Sockel(7) als zweite Halterung(7) gehalten wird.


9. Verfahren zur Herstellung des Gehäuses nach einem der Patentansprüche 1 bis 5, d a d u r c h   g e k e n n z e i c h n e t , daß
- vor dem Verschweißen des metallischen Abschnittes(innerhalb 1) mit der metallischen zweiten Halterung(7), ein metallisches Zwischenstück(8) an der zu verschweißenden Stelle(8) zwischen dem Abschnitt(innerhalb 1) und der
zweiten Halterung(7) angebracht wird.

10. Verfahren nach Patentanspruch 9,
d a d u r c h   g e k e n n z e i c h n e t ,  daß
- vor dem Verschweißen des metallischen Abschnittes(innerhalb 1) mit der metallischen zweiten Halterung(7), abseits der zu verschweißenden Stelle(8) sonstige Teile
  dieses Abschnittes(innerhalb 1) mit einer elektrisch
  schlecht schleitenden Lackschicht bedeckt wird.

1/1 0214464

Europäisches
Patentamt

EUROPÄISCHER RECHERCHENBERICHT

**0214464**
Nummer der Anmeldung

EP 86 11 0752

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| D,A | DE-A-3 337 131   (SIEMENS AG)<br><br>* Abbildungen 1,2; Anspruch 1; Seite 11, Zeilen 4-26; Seite 18, Zeilen 12-17 *<br><br>--- | 1,2,6-8 | H 01 L   31/02<br>G 02 B    6/42<br>H 01 L   33/00 |
| A | US-A-4 399 453   (H.M. BERG et al.)<br>* Insgesamt *<br><br>--- | 1,2,5-7 | |
| A | US-A-3 029 505   (G. REICHENBAUM)<br><br>--- | | |
| A | EP-A-0 111 264   (SIEMENS AG)<br><br>----- | | |

| RECHERCHIERTE SACHGEBIETE (Int Cl 4) |
|---|
| H 01 L<br>G 02 B<br>H 05 K |

Der vorliegende Recherchenbericht wurde für alle Patentansprüche erstellt

| Recherchenort | Abschlußdatum der Recherche | Prüfer |
|---|---|---|
| DEN HAAG | 10-10-1986 | VISENTIN A. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82